# EUROPÄISCHE PATENTANMELDUNG

(11) **EP 1 014 444 A1**
(43) Veröffentlichungstag der Anmeldung: **28.06.2000**
(21) Anmeldenummer: 99109646.2
(22) Anmeldetag: 14.05.1999
(51) Int. Cl.: H01L 23/31, H01L 21/78

(54) **Integrierter Schaltkreis mit Schutzschicht und Verfahren zu dessen Herstellung**

(71) Anmelder: SIEMENS AKTIENGESELLSCHAFT, 80333 München (DE)
(72) Erfinder: Steckhan, Hans-Hinnerk, 81827 München (DE); Schneider, Ludwig, 94365 Parkstetten (DE); Mueller, Jochen Dr., 93173 Wenzenbach (DE); Lang, Guenter, 90459 Nürnberg (DE); Kroeninger, Werner, 93073 Neutraubling (DE)

(57) **Zusammenfassung**

Zur kurzschlußfreien Kontaktierung von ICs werden die Seitenkanten der späteren ICs bereits auf dem Wafer und vor der Trennung in Einzelchips elektrisch isoliert.

Der integrierte Schaltkreis ist gekennzeichnet durch eine Isolierschicht (4), die so auf der Halbleiterstruktur (1a,1b) angeordnet ist, daß ein direkter elektrischer Kontakt zwischen Kontaktelementen (6) und der Halbleiterstruktur (1a,1b) unterbunden ist. Die Erfindung ist ebenfalls gerichtet auf ein Verfahren zur Herstellung eines integrierten Schaltkreises mit Isolierschicht (4) mit folgenden Schritten: Bereitstellen eines Wafers (1) mit zumindest zwei Halbleiterstrukturen (1a,1b); Ausformen von Keilrinnen (3) auf der Oberseite des Wafers (1) zwischen den zumindest zwei Halbleiterstrukturen (1a,1b); Beschichten zumindest der Keilrinne (3) mit einer Isolierschicht (4); Dünnen des Wafers (1) an seiner Unterseite bis zu einer Dicke, die geringer oder gleich der Tiefe der Keilrinne (3) ist; und Trennen der zumindest zwei Halbleiterstrukturen (1a,1b).

## Beschreibung

Beim Trennen integrierter Schaltkreise (ICs) aus dem Verband eines Wafers wird an deren Kanten, den Seitenkanten, das Wafergrundmaterial freigelegt. Darüber hinaus liegt im Trennbereich der einzelnen ICs das Wafergrundmaterial üblicherweise auch an der Oberseite des Wafers frei. Die vom IC wegführenden Kontaktleitungen dürfen nicht in Kontakt mit diesen freiliegenden Kanten gelangen, da es sonst zu Kurzschlüssen über das Substrat und damit verbundenen Funktionsstörungen kommen kann. Um solche Kurzschlüsse zu vermeiden, werden die abführenden Drähte nach oben, z.B. im Bogen, von den Halbleiterstrukturen der ICs weggeführt. Wenn die ICs allerdings in dünne Gehäuse eingebaut werden sollen, dürfen die Leitungen nicht wesentlich über die Oberfläche der ICs hinausragen, sondern müssen möglichst plan an die Oberfläche anschließen. Hierbei ist die Gefahr von Kurzschlüssen noch erhöht, da bereits bei kleinen Verschiebungen des Kontaktelements, z.B. im Rahmen der Fertigungstoleranz, ein Kontaktelement eine Verbindung mit dem Wafergrundmaterial kommen kann.

Eine im Stand der Technik vorbekannte Lösung dieses Problems besteht darin, einen Drahtbogen als Kontaktelement frei über die Kante des IC zu führen (sog. wire bond Technik). Ein weiterer Ansatz verwendet einen zusätzliche Metallaufbau (Bump), der auf einen Kontaktbereich aufgesetzt ist, um diesen zu erhöhen. Hierdurch werden bei geeigneter geometrischer Auslegung und unter Inkaufnahme einer Vergrößerung der Aufbauhöhe die Kontaktelemente so weit von den Seitenkanten der ICs entfernt gehalten, daß ein Kurzschluß vermieden werden kann.

In den letzten Jahren sind zunehmend flachere Gehäuseformen für ICs entwickelt worden, die derzeit in Chipkarten, Compact Flash Speichern und ähnlichem ihren Höhepunkt gefunden haben. Die weitere Miniaturisierung wird jedoch noch flachere Bauformen erfordern. Die bisherigen Ansätze zur kurzschlußfreien Kontaktierung von ICs reichen bei den modernen, ultraflachen Gehäusen nicht mehr aus. Bei diesen können bereits zusätzliche Aufbauten durch Bumps mit 50 bis 100 µm zu hoch sein.

Der vorliegenden Erfindung liegt daher die Aufgabe zugrunde, einen IC bereitzustellen, bei dem das bisherige trotz minimaler Aufbauhöhe keine Kurzschlüsse zwischen Kontaktelement und IC, insbesondere der IC-Seitenkante, auftreten können

Die vorliegende Erfindung löst diese Aufgabe durch die Bereitstellung eines integrierten Schaltkreises mit Schutzschicht gemäß den unabhängigen Ansprüchen 1 und 7, sowie durch das Verfahren zu ihrer Herstellung gemäß dem unabhängigen Patentanspruch 13. Weitere vorteilhafte Ausgestaltungen, Vorteile und Aspekte der vorliegenden Erfindung ergeben sich aus den abhängigen Ansprüchen, der Beschreibung und der beigefügten Zeichnung.

Der vorliegenden Erfindung liegt der Gedanke zugrunde, die Seitenkanten der späteren ICs bereits auf dem Wafer und vor der Trennung in Einzelchips elektrisch zu isolieren.

Demgemäß ist die Erfindung gerichtet auf einen integrierten Schaltkreis mit einer Halbleiterstruktur und einer Isolierschicht zumindest im Bereich der Seitenkanten der Halbleiterstruktur.

Unter einer Halbleiterstruktur im Sinne der vorliegenden Erfindung ist dabei ein Teil eines Wafers zu verstehen, der die Bauelemente der elektronischen Schaltung integriert enthält, also der IC im engeren Sinne.

Unter einer Isolierschicht im Sinne der vorliegenden Erfindung ist eine Beschichtung der Oberfläche der Halbleiterstruktur zu verstehen, die elektrisch isolierend ist.

Durch das Beschichten der Seitenkanten der Halbleiterstruktur mit der Isolierschicht wird verhindert, daß diese Seitenkanten, an denen das Wafergrundmaterial freiliegt, in elektrischen Kontakt mit Verbindungsdrähten oder sonstigen Kontaktelementen kommen können, was ansonsten zu einem Kurzschluß führen könnte.

Je nach Anordnung und Ausrichtung dieser Kontaktelemente kann es zudem wünschenswert sein, weitere Bereiche der Oberfläche des Wafers zu isolieren. Hierbei können solche Bereiche isoliert werden, an denen das Wafergrundmaterial auch an der Oberseite freiliegt, insbesondere solche Bereiche, über die später Kontaktelemente hinweggeführt werden. Auch ist es möglich, die gesamte Oberseite des Wafers mit einer Isolierschicht zu versehen.

Vorzugsweise lässt allerdings die Isolierschicht auch ausgewählte Bereiche der Halbleiterstruktur frei, beispielsweise Kontaktflächen, die auf der Halbleiterstruktur angeordnet sind und der Verbindung mit Kontaktelementen dienen. Es muß nicht unbedingt erforderlich sein, alle auf einer Halbleiterstruktur angebrachten Kontaktflächen freizuhalten, da es auch vorkommen kann, daß für einen bestimmten Verwendungszweck des IC nicht alle Kontakte benötigt werden.

In einem weiteren Aspekt ist die Erfindung auf einen integrierten Schaltkreis mit einer Halbleiterstruktur, Kontaktflächen auf der Halbleiterstruktur und Kontaktelementen zur elektrischen Kontaktierung der Kontaktflächen gerichtet. Dieser integrierte Schaltkreis ist erfindungsgemäß gekennzeichnet durch eine Isolierschicht, die so auf der Halbleiterstruktur angeordnet ist, daß ein direkter elektrischer Kontakt zwischen Kontaktelementen und der Halbleiterstruktur unterbunden ist.

Wie oben dargestellt, ist die Unterbindung von möglichen Kontakten besonders bei flachen Bauformen der IC-Packungen wichtig, also wenn die Kontaktelemente beispielsweise im wesentlichen parallel zur Halbleiterstruktur (und damit dicht über deren Oberfläche) verlaufen.

Vorzugsweise ist die Isolierschicht zumindest im Bereich der Seitenkanten der Halbleiterstruktur angeordnet, kann jedoch auch bis zur Oberseite der Halbleiterstruktur reichen und dort bestimmte Bereiche abdecken.

Die Erfindung ist weiterhin gerichtet auf ein Verfahren zur Herstellung eines integrierten Schaltkreises mit Isolierschicht mit folgenden Schritten:
- Bereitstellen eines Wafers mit zumindest zwei Halbleiterstrukturen;
- Ausformen von Keilrinnen auf der Oberseite des Wafers zwischen den zumindest zwei Halbleiterstrukturen;
- Beschichten zumindest der Keilrinne mit einer Isolierschicht;
- Dünnen des Wafers an seiner Unterseite bis zu einer Dicke, die geringer oder gleich der Tiefe der Keilrinne ist; und
- Trennen der zumindest zwei Halbleiterstrukturen.

Dieses Verfahren kombiniert in vorteilhafter Weise Beschichten, Dünnen und Trennen der Halbleiterstrukturen, da es durch das Beschichten zugleich möglich wird, bereits beim Dünnen die Halbleiterstrukturen zu vereinzeln, also mechanisch voneinander zu lösen, ohne das die Gesamtstruktur des Wafers zerfallen würde, da die vereinzelten Halbleiterstrukturen noch über die Isolierschicht in der Keilrinne oder über eine aufgeklebte Folie zusammenhängen. Das nachfolgende Trennen wird dadurch maßgeblich vereinfacht.

Die Keilrinne kann in üblicher Weise hergestellt werden, beispielsweise durch Schneiden mit einem keilförmig geformten Sägeblatt (ein sog. bevel cut); andere Verfahren zur Einbringung einer Kerbe (Keilrinne) können chemische oder plasmaunterstützte Ätzverfahren sein.

Vorteilhafterweise wird außer der Keilrinne weiterhin zumindest ein Teil der Oberseite der Halbleiterstrukturen beschichtet, beispielsweise ein solcher Bereich der Oberseite, bei dem das Wafergrundmaterial freiliegt und über den im fertigen IC Kontaktelemente geführt werden sollen.

Das Dünnen des Wafers kann beispielsweise durch Schleifen oder durch Ätzen erfolgen.

Nach dem Dünnen sind somit die einzelnen Halbleiterstrukturen nicht mehr über einen Waferbereich miteinander verbunden. Ein Zusammenhalt ist nur noch gegeben durch die in der Keilrinne vorhandene Isolierschicht und/oder durch eine Folie, welche auf die Oberseite des Wafers aufgeklebt wird.

Das Beschichten kann in einer bevorzugten Ausführungsform des erfindungsgemäßen Verfahrens folgende Schritte aufweisen:
- Beschichten der gesamten Waferoberfläche mit der Isolierschicht;
- Strukturieren der Beschichtung, so daß nur ausgewählte Bereiche erhalten bleiben.

Das Strukturieren erfolgt beispielsweise durch ein photolithographisches Verfahren, bei dem in dem Fachmann geläufiger Weise eine maskierte Folie auf den Wafer aufgebracht wird, mittels UV belichtet wird und die nicht maskierten Bereiche der Isolierschicht weggeätzt werden.

Die zumindest zwei Halbleiterstrukturen des Wafers können vor dem Beschichten mit zumindest je einer Kontaktfläche versehen werden.

Das Strukturieren der Isolierschicht kann dabei so erfolgen, daß die Kontaktflächen freigelegt werden.

Das Trennen erfolgt vorzugsweise dadurch, daß die Isolierschicht zwischen den zumindest zwei Halbleiterstrukturen entfernt wird. Dabei kann das Entfernen der Isolierschicht zwischen den zumindest zwei Halbleiterstrukturen durch das Dünnen des Wafers erfolgen, wenn dieses beispielsweise mittels Schleifen erfolgt.

Alternativ kann das Trennen dadurch erfolgen, daß die Abstände zwischen den zumindest zwei Halbleiterstrukturen so vergrößert werden, daß die Isolierschicht zwischen den Halbleiterstrukturen reißt.

Diese Vergrößerung der Abstände zwischen den zumindest zwei Halbleiterstrukturen erfolgt vorzugsweise dadurch, daß auf den Wafer eine Folie geklebt wird und diese Folie gereckt wird.

Die Isolierschicht besteht vorzugsweise aus einem Polyimid, einem Polybenzoxazol oder einem Benzocyclobuten-Polymer. Besonders bevorzugt sind Isolierschichten aus Polyimid.

Die Isolierschicht weist vorzugsweise eine Dicke von 1 bis 10 µm auf. Besonders bevorzugt ist, daß die Isolierschicht eine Dicke von etwa 3 µm aufweist.

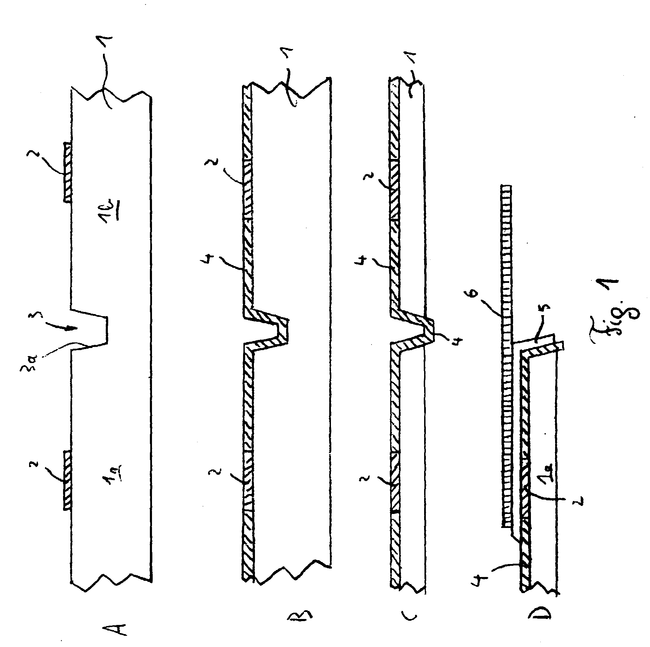

Im folgenden soll die Erfindung anhand von Ausführungabeispielen erläutert werden, wobei auf die Figur 1 Bezug genommen werden soll, in der verschiedene Stadien des erfindungsgemäßen Beschichtungsverfahrens dargestellt sind.

Ausgangspunkt ist ein herkömmlich fertiggestellter Wafer 1 mit einer Reihe von Halbleiterstrukturen (1a, 1b) die in den erfindungsgemäßen integrierten Schaltkreisen Verwendung finden sollen. Wie in Fig. 1 A dargestellt, werden auf der Oberseite des Wafers Kontaktflächen 2 angebracht, welche den späteren elektrischen Kontakt des ICs mit seiner Umgebung herstellen sollen, indem an ihnen Drähte oder sonstige Kontaktelemente angebracht werden. Zwischen den Halbleiterstrukturen werden zu deren späterer Trennung Keilrinnen 3 mit Seitenwänden 3a eingeschnitten oder geätzt. Im Bereich dieser Rinnen liegt das Wafergrundmaterial offen. Je nach Genauigkeit des Schnitts kann vom Materialabtrag auch ein Bereich seitlich der Keilrinnen an der Oberseite des Wafers betroffen sein, wo das Wafergrundmaterial dann ebenfalls freigelegt wird. Darüber hinaus kann bereits zuvor die bei der Herstellung der integrierten Schaltkreise verwendete Prozeßtechnik diesen Bereich bis auf das Wafergrundmaterial freigelegt haben.

In Fig. 1 B ist dargestellt, daß eine Isolierschicht 4 auf die Oberseite des Wafers aufgebracht wird. Die Isolierschicht wird daraufhin strukturiert, so daß die Kontaktflächen 2 freigelegt werden.

In Fig. 1 C ist der Zustand des Wafers nach dem Dünnen dargestellt. Der Wafer ist bis auf eine Dicke gedünnt, die geringer ist als die Tiefe der ehemaligen Keilrinne 3. Somit sind die Halbleiterstrukturen im Bereich der Keilrinnen schon vereinzelt, die Struktur hängt aber noch über die Ausformung der Isolierschicht im Bereich der Keilrinnen zusammen. Auf die Isolierschicht kann zudem noch eine stabilisierende Folie aufgeklebt sein, die ein vorzeitiges Reißen der Isolierschicht verhindert.

Fig. 1 D zeigt den Zustand einer Halbleiterstruktur nach dem Trennen der einzelnen Halbleiterstrukturen. Eine Kontaktschicht 5 ist auf der Isolierschicht 4 aufgebracht, um den elektrischen Kontakt zwischen Kontaktfläche 2 und Kontaktelement 6 sicherzustellen. Diese Kontaktschicht 5 kann zugleich der mechanischen Befestigung des Kontaktelements 6 auf der Isolierschicht 4 dienen.

Das Verfahren wurde in einer praktischen Ausführung erprobt. Die oberflächliche Kerbe (Keilrinne) wurde mit einem konischen Sägeblatt mit einem Neigungswinkel von 60→ bis in eine Tiefe von 70 µm eingebracht. Eine Polyimidschicht von 3 µm Dicke wurde anschließend durch Kontaktbelichtung strukturiert, so daß die Keilrinne und das auf der Oberseite freiliegende Grundmaterial des Wafers abgedeckt blieben. Das Dünnen des Wafers erfolgte durch Schleifen bis zu einer Dicke von 140 µm und anschließende Ätzen auf 40 µm. Der durch eine Schleifätzfolie an seiner Oberseite zusammengehaltene Wafer wird danach auf seiner Rückseite auf eine Sägefolie umgeklebt. Die die Halbleiterstrukturen in der Keilrinne verbindende Polyimidschicht wird durch Dehnen der Folie des Wafers getrennt. Die Einzel-ICs lassen sich anschließend für das Kontaktierverfahren entnehmen.

Die erfindungsgemäße Isolierschicht ermöglicht die Herstellung noch flacherer Gehäuseformen ohne ein erhöhtes Risiko für Kurzschlüsse und Fehlfunktionen. Das Herstellverfahren ist einfach und mit Standardmitteln der Halbleiterfabrikation durchführbar.

## Patentansprüche

1. Integrierter Schaltkreis mit einer Halbleiterstruktur (1a) und einer Isolierschicht (3) zumindest im Bereich der Seitenkanten (3) der Halbleiterstruktur (1a).

2. Schaltkreis nach Anspruch 1, dadurch gekennzeichnet, daß die Isolierschicht (3) ausgewählte Bereiche der Halbleiterstruktur freiläßt.

3. Schaltkreis nach Anspruch 2, dadurch gekennzeichnet, daß auf der Halbleiterstruktur Kontaktflächen angeordnet sind und die Isolierschicht diese Kontaktflächen (2) freiläßt

4. Schaltkreis nach einem der Ansprüche 1 bis 3, dadurch gekennzeichnet, daß die Isolierschicht aus einem Polyimid, einem Polybenzoxazol oder einem Benzocyclobuten-Polymer besteht.

5. Schaltkreis nach einem der Ansprüche 1 bis 4, dadurch gekennzeichnet, daß die Isolierschicht eine Dicke von 1 bis 10 µm aufweist.

6. Schaltkreis nach Anspruch 5, dadurch gekennzeichnet, daß die Isolierschicht eine Dicke von etwa 3 µm aufweist.

7. Integrierter Schaltkreis mit einer Halbleiterstruktur (1a), Kontaktflächen (2) auf der Halbleiterstruktur (1a) und Kontaktelementen (6) zur elektrischen Kontaktierung der Kontaktflächen (2), gekennzeichnet durch eine Isolierschicht (3), die so auf der Halbleiterstruktur (1a) angeordnet ist, daß ein direkter elektrischer Kontakt zwischen Kontaktelementen (6) und der Halbleiterstruktur (1a) unterbunden ist.

8. Schaltkreis nach Anspruch 7, dadurch gekennzeichnet, daß die Kontaktelemente (6) im wesentlichen parallel zur Halbleiterstruktur (1a) verlaufen.

9. Schaltkreis nach Anspruch 7 oder 8, dadurch gekennzeichnet, daß die Isolierschicht zumindest im Bereich der Seitenkanten der Halbleiterstruktur angeordnet ist.

10. Schaltkreis nach einem der Ansprüche 7 bis 9, dadurch gekennzeichnet, daß die Isolierschicht aus einem Polyimid, einem Polybenzoxazol oder einem Benzocyclobuten-Polymer besteht.

11. Schaltkreis nach einem der Ansprüche 7 bis 10, dadurch gekennzeichnet, daß die Isolierschicht eine Dicke von 1 bis 10 µm aufweist.

12. Schaltkreis nach Anspruch 11, dadurch gekennzeichnet, daß die Isolierschicht eine Dicke von etwa 3 µm aufweist.

13. Verfahren zur Herstellung eines integrierten Schaltkreises mit Schutzschicht (4) mit folgenden Schritten:
- Bereitstellen eines Wafers (1) mit zumindest zwei Halbleiterstrukturen (1a, 1b);
- Ausformen von Keilrinnen (3) auf der Oberseite des Wafers (1) zwischen den zumindest zwei Halbleiterstrukturen (1a, 1b);
- Beschichten zumindest der Keilrinne (3) mit einer Isolierschicht (4);
- Dünnen des Wafers (1) an seiner Unterseite bis zu einer Dicke, die geringer oder gleich der Tiefe der Keilrinne (3) ist; und
- Trennen der zumindest zwei Halbleiterstrukturen (1a, 1b).

14. Verfahren nach Anspruch 13, dadurch gekennzeichnet, daß weiterhin zumindest ein Teil der Oberseite der Halbleiterstrukturen (1a, 1b) beschichtet wird.

15. Verfahren nach Anspruch 13 oder 14, dadurch gekennzeichnet, daß das Dünnen durch Schleifen erfolgt

16. Verfahren nach Anspruch 13 oder 14, dadurch gekennzeichnet, daß das Dünnen durch Ätzen erfolgt

17. Verfahren nach einem der Ansprüche 13 bis 16, dadurch gekennzeichnet, daß das Beschichten folgende Schritte aufweist:
- Beschichten der gesamten Waferoberfläche mit der Isolierschicht
- Strukturieren der Beschichtung, so daß nur ausgewählte Bereiche erhalten bleiben.

18. Verfahren nach Anspruch 17, dadurch gekennzeichnet, daß das Strukturieren durch ein photolithographisches Verfahren erfolgt.

19. Verfahren nach einem der Ansprüche 17 bis 18, dadurch gekennzeichnet, daß die zumindest zwei Halbleiterstrukturen des Wafers vor dem Beschichten mit zumindest je einer Kontaktfläche versehen werden.

20. Verfahren nach Anspruch 18, dadurch gekennzeichnet, daß das Strukturieren der Isolierschicht so erfolgt, daß die Kontaktflächen freigelegt werden.

21. Verfahren nach einem der Ansprüche 13 bis 20, dadurch gekennzeichnet, daß das Trennen dadurch erfolgt, daß die Isolierschicht zwischen den zumindest zwei Halbleiterstrukturen entfernt wird.

22. Verfahren nach Anspruch 21, dadurch gekennzeichnet, daß das Entfernen der Isolierschicht zwischen den zumindest zwei Halbleiterstrukturen durch das Dünnen des Wafers erfolgt.

23. Verfahren nach einem der Ansprüche 13 bis 20, dadurch gekennzeichnet, daß das Trennen dadurch erfolgt, daß die Abstände zwischen den zumindest zwei Halbleiterstrukturen so vergrößert werden, daß die Isolierschicht zwischen den Halbleiterstrukturen reißt.

24. Verfahren nach Anspruch 2, dadurch gekennzeichnet, daß die Vergrößerung der Abstände zwischen den zumindest zwei Halbleiterstrukturen dadurch erfolgt, daß auf den Wafer eine Folie geklebt wird und diese Folie gereckt wird.

25. Verfahren nach einem der Ansprüche 13 bis 24, dadurch gekennzeichnet, daß die Isolierschicht aus einem Polyimid, einem Polybenzoxazol oder einem Benzocyclobuten-Polymer besteht.

26. Verfahren nach einem der Ansprüche 13 bis 25, dadurch gekennzeichnet, daß die Isolierschicht eine Dicke von 1 bis 10 µm aufweist.

27. Verfahren nach Anspruch 25, dadurch gekennzeichnet, daß die Isolierschicht eine Dicke von etwa 3 µm aufweist.
